# EUROPEAN PATENT SPECIFICATION

(11) **EP 0 321 286 B1**
(45) Date of publication and mention of the grant of the patent: **06.10.1993**
(21) Application number: 88311949.7
(22) Date of filing: 16.12.1988
(51) Int. Cl.: H01R 43/28, H05K 13/06

(54) **Method and apparatus for electrical wiring of structural assemblies**
Verfahren und Vorrichtung für elektrische Verdrahtung von Montagestrukturen
Procédé et dispositif de câblage électrique des assemblages structuraux

(30) Priority: 17.12.1987 US 134328
(43) Date of publication of application: 21.06.1989
(73) Proprietor: THE WHITAKER CORPORATION, Wilmington, Delaware 19808 (US)
(72) Inventor: Sergeant, Ronald Gilbert, Miami Florida 33178 (US); Sykora, Allan Jack, Kernersville North Carolina 27284 (US)
(74) Representative: Warren, Keith Stanley

(56) References cited:
- DE-A- 2 133 241
- FR-A- 2 507 853
- US-A- 3 840 962
- US-A- 3 891 013
- US-A- 4 684 765

## Description

The present invention relates to a method and apparatus for harness making wherein the electrical conductor wires which form the harness are implanted into a frame which is a structural member of the apparatus served by the harness with components added to such frame and the frame being mounted into the apparatus served thereby.

Electrical harnesses are typically made of electrical conductor wires which are mostly individual, stranded, and insulated wires with an occasional uninsulated stranded or solid wire utilized for grounding or the like. These wires are typically terminated by electrical terminals and/or connectors and formed into some general shape suitable for inventory and handling by the use of tape or harness ties. Fasteners may or may not be employed to affix the harness to the apparatus in which the harness is used. The harness wires serve the function of supplying power to the various components of such apparatus or signals for either control or machine intelligence purposes and, as mentioned, ground and/or shielding circuit functions. The harness may be a simple one, having only several short wires but a few inches in length utilized to interconnect the components of a simple circuit in an apparatus such as a camera or smoke alarm or, it may have literally hundreds of wires terminated in very expensive connectors and utilized to interconnect all of the different devices and components of a complex circuit as in an aircraft. The harness may be premade in large part to be loaded into the apparatus on a production line as, for example, with respect to appliances such as washers, dryers, copy machines, stoves, refrigerators and the like; or, added piece meal in subassembly fashion as the apparatus moves along a production line. Generally speaking, a harness is a flexible assembly having a non-rigid shape, such as a plurality of discrete wires which are bundle tied together and terminated at ends thereof for interconnection to a panel or other end components. These harnesses are difficult to handle by machine, making if difficult to automate either harness making or harness handling. This fact has frustrated industry for decades and, notwithstanding substantial efforts to automate or robotize harness making or harness manipulation, most harnesses are currently manufactured and installed in a highly labor intensive manner which impacts not only on cost but also on quality.

A significant step automatic wire handling in the last decade has come with the concept of implanting conductor wires into preformed grooves having a desired geometry and/or distribution. This technique is taught in U.S Patent Numbers 3,891,013 and 3,871,072, as well as in U.S. Patent Number 4,076,365. These patents deal with spreading conductors for the purpose of location for termination and, in the latter case, include grooves in the connector housing into which conductor wires are driven. U.S. Patent Number 4,132,251 teaches a similar concept but employs a tool which rolls the wires into the grooves. A further teaching yet is found in U.S Patents 4,132,252 and 4,125,137 relating to rolling techniques wherein wires are spread into grooves by rolling tools preparatory to termination.

The wire implanting technique disclosed in this prior art allows a number of wires to be positioned and placed rather exactly for subsequent processing such as termination in an automatic or semiautomatic fashion which minimizes the need for labor in handling the different wires and vastly increases the productivity for such wire handling and placement. It represents, nevertheless, only a fraction of the overall labor in forming harnesses or subharnesses, the nature of the harness in being flexible and difficult to handle remaining as a challenge.

According to one aspect thereof the invention consists in harness making apparatus as defined in claim 1 and according to another aspect thereof the invention consists in a method as defined in claim 6

FR-A- 2 507 853 discloses a harness making method according to the preamble of claim 6.

The grooves in the structural element are disposed to allow the implanting technique heretofore mentioned to distribute wire between X and Y points in the element and thus in the apparatus. The wires are terminated at the ends or elsewhere along the length thereof in accordance with the needs of the wiring harness and related circuits. The invention method embraces concepts of rolling in order to implant wires. It does this by disposing the roller along a path which traverses X and Y directions over the structural elements; or, the use of distinct rolling steps by one or more rollers. The method of using embraces rolling from the end of a structure such as the end of a frame element or, rolling from the middle of such structure up and then down to effect wire distribution. The apparatus embraces the use of grooves in the structural element along with portions thereof which may be deformed to hold wires therewithin. An embodiment of the invention involves the termination of the wires by specially adapted terminals which fit into the frame element, by connectors which similarly are attached to the frame element, and by components which plug into the frame element and are attached thereto.

US-A- 4 684 765 discloses an insulation displacement terminal having a slot for terminating a wire spanning an aperture in a frame.

Accordingly, it is an object of the present invention to provide a method and apparatus for producing electrical wiring harnesses and wire distribution incorporated into the structural elements of an apparatus unit. It is a further object of the invention to provide a better way to install conductive wires into devices and apparatus which require a harness. It is still a further object to provide a wire distribution and manipulation technique which lends itself to automation. It is a further object to provide a method and apparatus which allows the manufacture of harnesses, termination of conductive wires, and addition of components through the use of a novel structural element designed into the apparatus requiring wiring, termination, connectors, components,and the like. It is a final object of the invention to provide a method and apparatus which improves the technique of wiring and component interconnection.

Embodiments of the invention will now be described by way of example

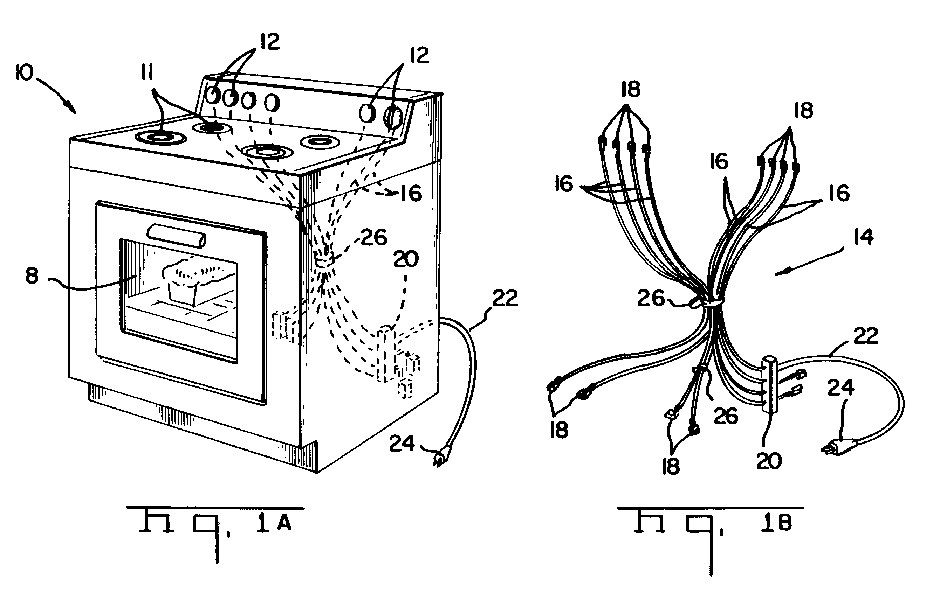

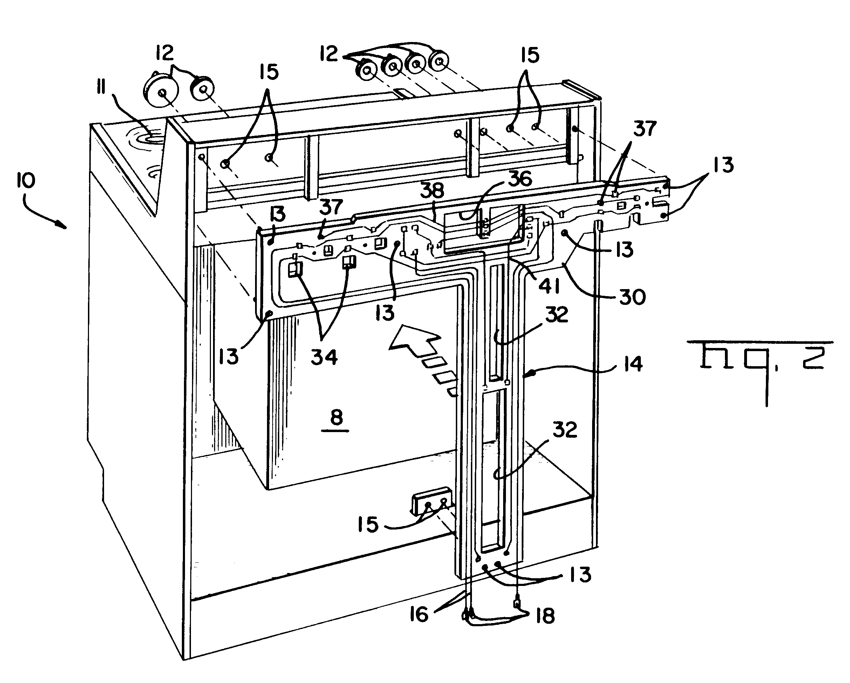

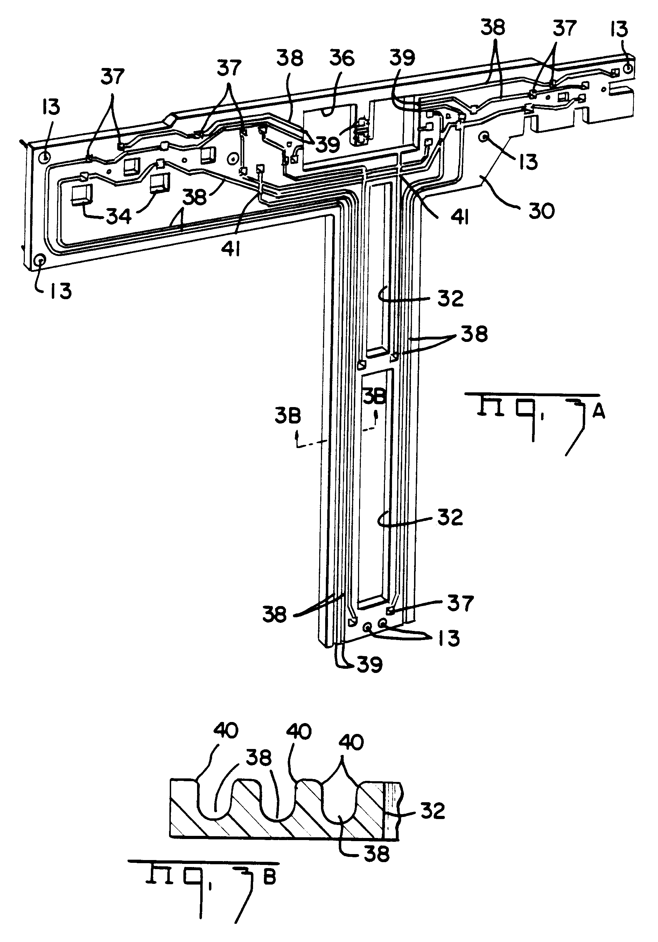

with reference to the accompanying drawing : Figures 1A and 1B are schematic representations, shown in perspective, of an electric range representing a typical apparatus unit along with its harness in accordance with prior art practice.

Figure 2 is a schematic view, in perspective, of the rear of an electric range, partially exploded to show the wire retaining frame as it relates to such range.

Figure 3A is a perspective view of the frame element as shown in Figure 2 but prior to being wired.

Figure 3B is a cross-sectional view of a portion of the frame of Figure 3A showing wiring grooves in greater detail.

Figure 4 is a perspective of the frame shown in Figure 3A but from the front side thereof to include frame connector details.

Figure 5A is a perspective showing a jig fixture adapted to receive the frame shown in Figure 3A in conjunction with a roller device.

Figure 5B is a view of the jig fixture of Figure 5A with the frame mounted thereon and the roller positioned preparatory to the implantation of wires in the frame.

Figure 5C is a side and elevational view of the roller as disposed in Figure 5B.

Figure 5D is a cross sectional view through lines 5D-5D of Figure 5C showing the roller implanting wires in the frame element.

Figure 6A is a perspective view showing a segment of the frame including wire retention details.

Figure 6B is a plan view of segment of the frame including wire retention details of an alternative version.

Figure 6C is a section taken through the wire retention portion of Figure 6B.

Figure 6D is a perspective showing a partial phantom the details of wire cross over in the frame.

Figure 7A is a perspective view of the rear of the frame element of the invention with terminals shown just prior to insertion for wire termination.

Figure 7B is an enlarged view of the wire termination features including the terminal shown in perspective relative to the frame wire and anvil tooling.

Figure 8 is a view of the frame just prior to the addition of components thereto and following wiring and termination thereof.

Figure 9 is a view of an alternative embodiment illustrating numerous structural elements having free standing and relatively flexible wire between the elements.

Figure 10 is a view of a fixture which can be used to insert the wires into the configuration as shown in Figure 9.

Figure 11 is a view of an alternative fixture which can be used to insert the wires into the configuration as shown in Figure 9.

Referring now to Figure 1A, there is shown an apparatus unit 10 in the form of an electric range having a typical array of top placed burners shown as 11, panel front controls evidenced by knobs 12, and an oven 8. The unit 10 is included to typify a variety of electrical or electronic units representing apparatus requiring a conductive wiring harness suitably terminated and having components which cause the apparatus to function. In general, the wiring harness which is schematically represented in Figure 1B and is shown in phantom in Figure 1A installed in the unit 10, both labeled 14, includes a number of electrical conductor wires 16 terminated by terminals or connectors containing terminals labeled 18. A number of wires, typically power carrying wires are further terminated by terminal block 20 to which is connected in use a power cord shown as 22 having at the end the usual utility plug labeled 24. Harnesses such as 14 typically include tape or wire ties as at 26 which fasten the harness wires together and form the different branches thereof. Not shown but understood are additional fastening means which secure the harness within the apparatus unit 10 in an appropriate pattern to interconnect the components contained within the apparatus unit.

Harnesses such as 14 typically contain conductive wires of stranded copper which are principally 14 to 18 AWG in size, with several of the power wires requiring 8 to 12 AWG conductors. Certain of the signal wires are typically on the order of 18 to 22 AWG in size and typically the wires are insulated with protective insulating sheaths, but with one or several of the wires being uninsulated and serving to carry the ground or neutral voltages of an alternating current power supply. The trend to more electronic controls in lieu of electro-mechanical devices has witnessed the use of insulated wires of smaller and smaller gauge due to reduced current and voltage requirements which tends to make harnesses even more difficult to handle due to the reduced size and increased flexibility and in a sense, fragility of the harness.

Present practice has the individual wire 16 which comprise harness 14 being run on automatic wire handling machines which measure, cut and strip each end of the wires and may terminate one or both or such ends individually. Sets of appropriate wires of appropriate lengths and types are then laid up on what is known as a harness board, most typically made of plywood having nails, screws or other elements affixed thereto to mark the outline of the harness. With the wires laid up, they are suitably taped or bound by harness wire tires with connectors or terminals blocks or other parts of the harness added by hand as a part of the fabrication process. Harnesses thus assembled are then inventoried in an appropriate volume for subsequent transportation and installation into apparatus units such as 10 on a production line where such units are manufactured. As a general practice, the unit 10 has its various electrical and electronic components other than the harness placed upon portions of the unit structure and secured thereto with the harness then being added after all the components have been installed withe the appropriate connectors plugged to tab terminals contained on such components. Alternatively, some components are added to the harness prior to its installation.

It is this general approach which has made automation of harness making difficult and even where a degree of automation has been achieved, complicated installation of the flexible harness into the unit served thereby to a point that manual labor is required to be employed. Furthermore, the overall process of manufacturing and inventorying harnesses, storing, shipping and then installing harnesses on a production line is fundamentally incapable with "just in time" manufacturing procedures so desirable in mass production.

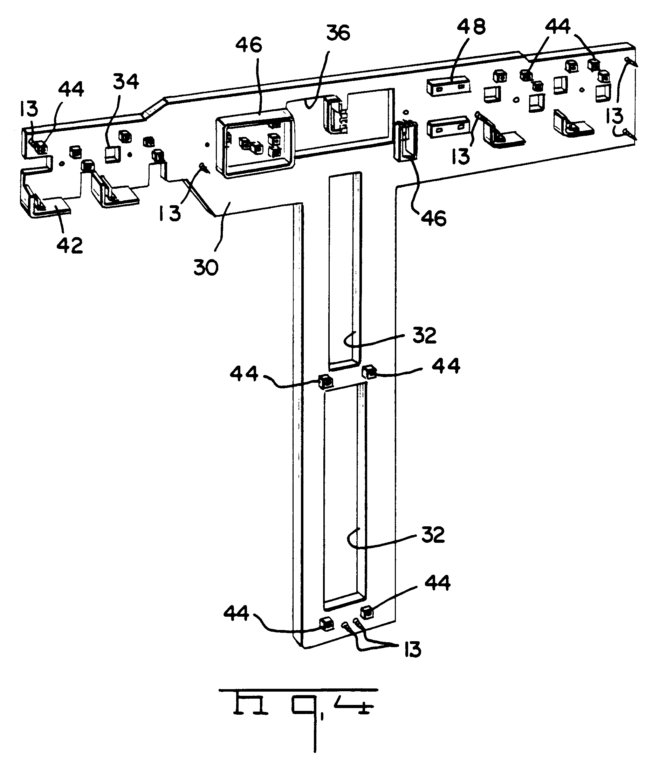

Figure 2 represents an alternative and improved approach related to the method and apparatus of the invention. In Figure 2, the harness 14 for the unit 10 is carried on a frame element 30 which is shown removed from the unit 10 for illustration. In conjunction with the use of the term "frame element", it is to be understood that the frame is structural and that the term structural should be taken in the context to mean that the frame serves a function in addition to or other than as merely an electric wire coordinator or means of mounting conductor wires. The frame or brace elements may be mechanically structural and support compressional or tensional loads in a given apparatus unit. Alternatively, structural may mean that the element serves as a panel to cover over for utilitarian purposes the front, rear, top, side, or bottom of a given apparatus unit. Further to be understood is that the structural element may be buried within the apparatus to block access or seal off areas therewithin, as for example, within the door of an automobile or other vehicle. The structural element may be part of a panel or cover having utilitarian purposes and as well, esthetic value as the front or side panels of a computer housing.

With respect to the teaching of Figure 2, the frame element 30 serves the disclosed purpose of functioning as a rack or mounting means for the distribution of wires 16 and terminals 18 as well as a means to provide interconnection and mechanical mounting of such interconnections. As will be hereinafter described, the frame also serves to mount components which are attached thereto.

Shown in Figure 2 as part of the frame 30 are a series of mechanical fasteners illustrated by the showing of screws 13 which are carried in the frame as indicated and which engage and mate with apertures 15 in the frame of the unit 10. With the unit 30 secured as by the screws 13, the frame adds a structural bracing to the unit 10.

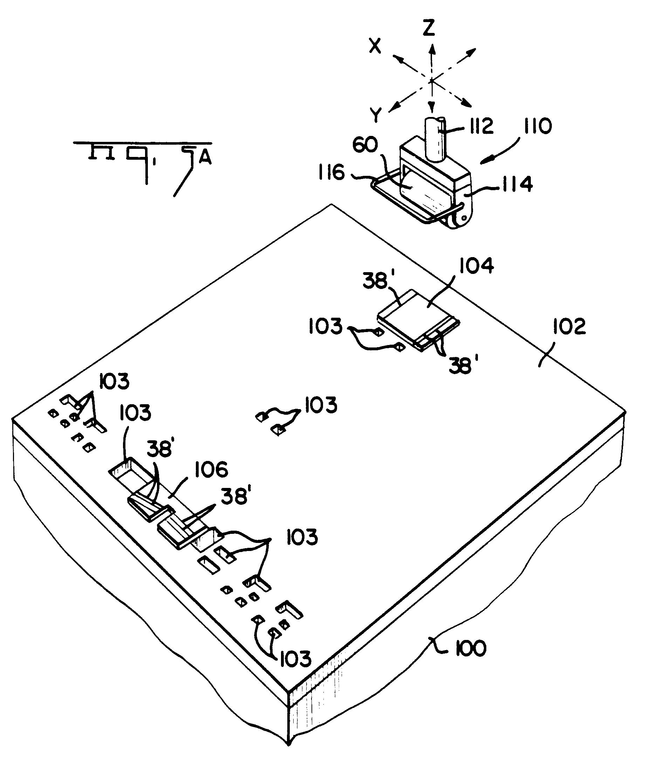

Referring now to further details of the frame unit 30, Figure 3A shows a number of apertures including apertures 32 in the stem of the T of the frame which act to lighten and reduce the use of material in the frame. Apertures shown as 34 and 36 serve the same function and additionally, provide access to portions of the range beneath the frame and/or to components mounted thereon.

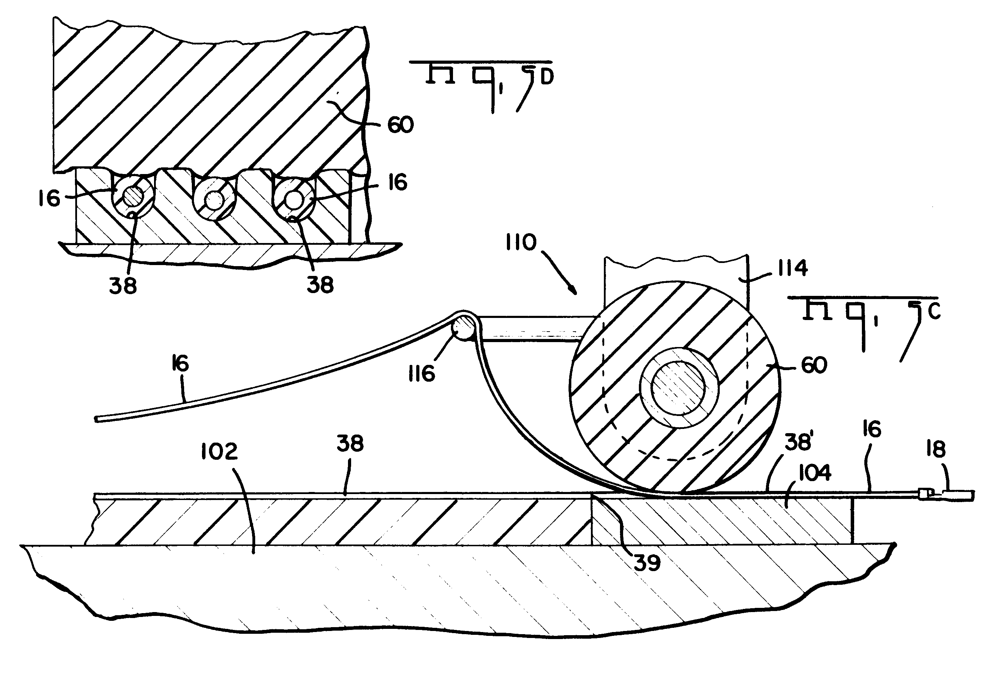

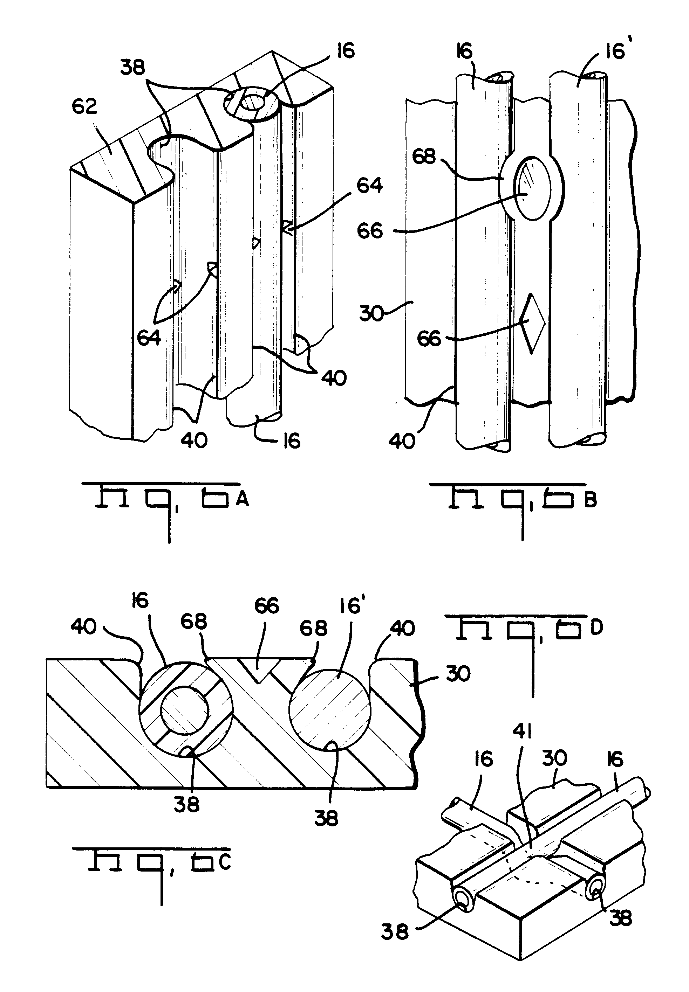

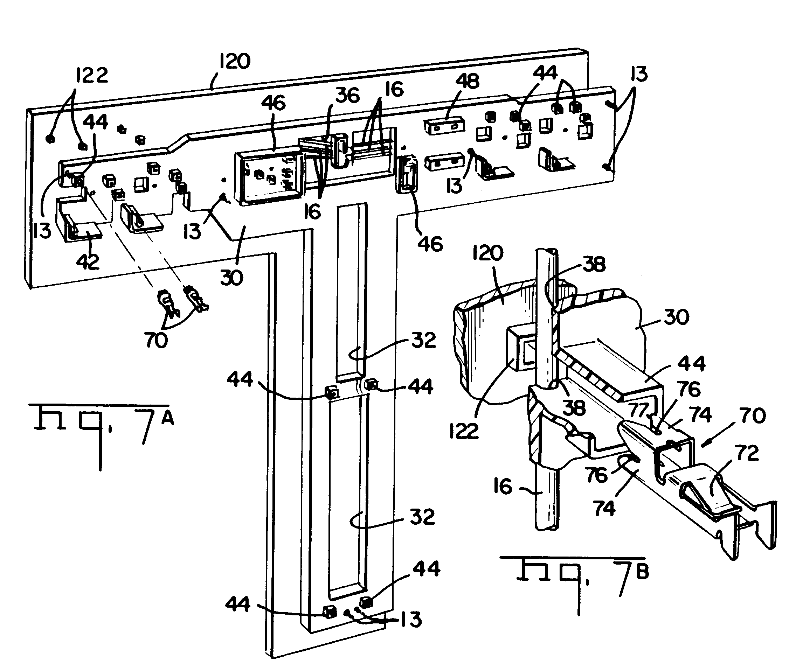

Referring now to Figure 3A, the frame 30 is shown with the harness wires removed so as to reveal a series of further apertures 37 through which are positioned terminals not shown which interconnect to the conductor wires mounted on the frame as will be hereinafter described in greater detail relative to Figure 7A and 7B.

As can be seen particularly in Figures 3A and 3B, the frame 30 includes a series of grooves 38 formed in the body thereof to receive wire 16. Figure 3B shows in cross section the lower left leg of frame 30 and it is to be noted that the detail of the grooves 38 includes a rounding in the bottom to accommodate wire laid therein and also a generally rounded or broken surface edge 40 which makes for an easy rolling entry of the wire 16 and tends to guide the wires into the grooves. To be noted also in Figure 3A is the fact that the grooves 38 open at a number of places in the frame such as at 39 at the bottom end of the frame or in certain instances, into the apertures 37 distributed within the body of the frame. Also to be noted are certain cross over points shown as 41 which can and do occur throughout the pattern of grooves on the frame. As can be seen in the top center portion of frame 30, grooves 38 open also as at 39 around the periphery of the portions of the surfaces of aperture 36.

In an actual embodiment, frames such as 30 would be made in a variety of ways including by being molded of plastic or thermoformed as by vacuum forming of plastic sheet material. If is also contemplated that the frame may be stamped and formed of sheet metal such as steel or aluminum with all or portions of the surfaces thereof coated with a protective and insulating plastic material. In instances where fully insulated wire is employed, the frame so formed may be left with a simple oxidation resistant finish. The choice of material for the frame will, of course, depend upon the use, the need for strength, cost and tooling investment factors, and the like. Worth mentioning is the use for frame material of the so-called RIM method which stands for a Reaction Injection Molding process. RIM materials provide low mold cost since the molding takes place under very much reduced pressures and, more importantly to the present disclosure, it is a material which is light, readily deformed, having a somewhat porous characteristic.

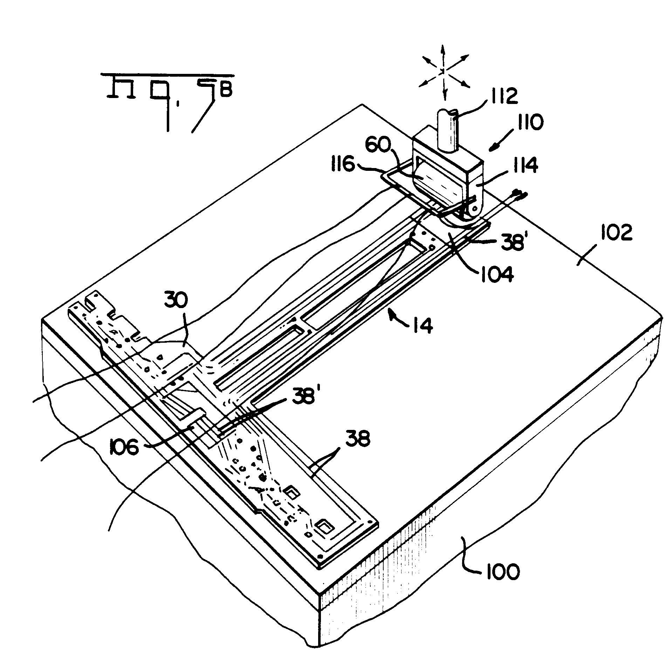

Figure 4 shows the reverse side of frame 30 from that shown in Figure 3A and reveals a number of projections which are molded or otherwise formed in a plastic material version of the frame. These projections are shown as 42, 44, 46, and 48 and represent different forms of extensions of the frame material to provide insulating, mounting, and protective functions relative to connector and component mounting. The projections 42 serve as an insulation and mounting means for the insertion of components which will be hereinafter described. Projections 44 surround and protect terminals fitted therewithin in a manner to be described relative to Figure 7B. Projections 46 and 48 serve similar functions with respect to sets of terminals and with respect to components plugged therein. In manufacture of the frames the projections 42 to 48 may be integrally formed of the frame material as shown or; alternatively, being made of separate plastic or metal pieces attached by suitable fastenings to the base frame member at a later time. Versions where the projections may be in part integrally formed and in part added to the frame for electrical insulation or mechanical fastening of components are also contemplated. Note in Figure 4 the presence of premounted screws 13 which are carried in the frame for mounting of the frame into the unit 10.

Turning now to the wire implantation technique, reference is made to Figure 5A. There represented is a table or jig base 100 carrying a jig 102 on the surface thereof, the jig may be seen to contain a series of recesses 103 adapted to accommodate the projections 42-48 heretofore described with respect to the frame element 30 and which in certain instances may serve to ease loading of the frame upon the jig by helping in alignment in the event of manual loading, and at least to preclude misalignment in the event of automatic or robotic loading. Included as part of the jig fixture 102 are a number of projections shown as 104 and 106. The projection 104 is in essence a tool having grooves 38' therein which match up with the grooves 38 in the frame element 30. The fixture element 106 has similar grooves 38' which match up with the grooves proximate to the aperture heretofore described as 36 in the top T part of frame 30. Shown positioned above the base 100 and jig fixtures contained thereon is an assembly 110 comprised of a supporting shaft 112 having brackets 114 carrying thereon a roller shown as 60. Secured to the roller is a bail mechanism 116 which preferably is added to the roller support bracket 114 and easily opened for loading of wires 16 to assist in implementation of wire implantation. Relative to the embodiment of Figure 5A, it is contemplated that the shaft 112 would be fitted into an end effector retaining aperture of a robotic arm capable of driving the mechanism 110 in X, Y and Z movements indicated by the representation above the mechanism 110 in Figure 5A.

Figure 5B shows the frame element 30 positioned on the surface of the jig fixture 102 with the jig elements 104 and 106 engaging the frame as shown. As can be discerned, the tooling elements 104 and 106 have their grooves 38′ aligned with the grooves 38 of the frame 30. As shown in Figure 5B and 5C, the wires 16 preterminated as at 18 in this example, are placed through the bail 116 with wire end segments inserted into the grooves 38′ of element 104. The wires 16 emerge from the grooves 38′ of element 104 proximate to the entry surfaces 39 heretofore described and as shown in Figure 5C. The roller 60 is brought downwardly to bear against the top of the element 104 and then the mechanism 110 is caused to move in an initial Y direction, pressing the wires 16 into the grooves of the frame 30 as is depicted in Figure 5D.

The roller 60 is made of elastomeric material of a sufficient flexibility to press the wire 16 beneath the surface of the frame 30. As an alternative construction, the roller 60 may be formed of the composite metal core having a sleeve of elastomeric material thereover sufficient to effect the deformation shown in Figure 5D. The mechanism 110 and roller is driven in a path represented by the dotted line in Figure 5B to implant the three wires that are there shown. It is to be understood that in many instances there would be fewer wires and in most instances, a greater number of wires implanted in grooves in frames.

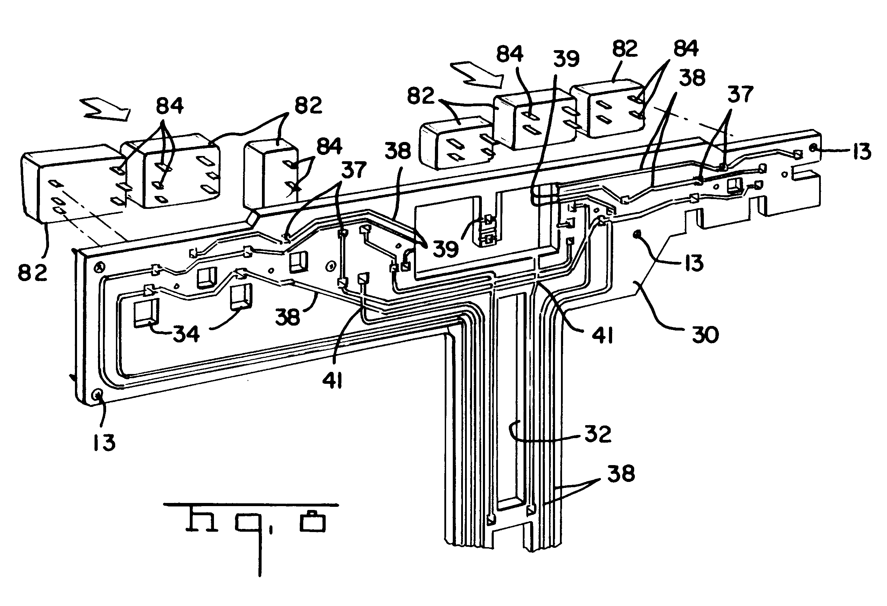

Referring back to Figure 3A, it will be apparent that there is need to add additional wires which do not start at the bottom end of the T-shaped frame but rather at the apertures 37 located within the body of the frame. It will also be discerned that certain of the wires begin in the top right-hand portion of the T-shaped frame and end in such top portion. These wires would need to be added subsequent to the initial rolling operation shown in Figure 5B. The relative movement between the roller and the jig fixture embraces having the roller track or turn as is necessary to accommodate the bends of the grooves 38 as well as initiating and effecting roller sweeps in X or Y or X and Y paths traversing the surface of the frame element 30. As a part of the invention, the use of the jig fixture tooling element 106 allows wires to be laid continuously along the grooves 38 in the frame element and through the grooves 38′ in the surface of the tooling fixture element 106. With the frame removed from the jig, these wires will be left free standing as is shown in Figures 7A and 8.

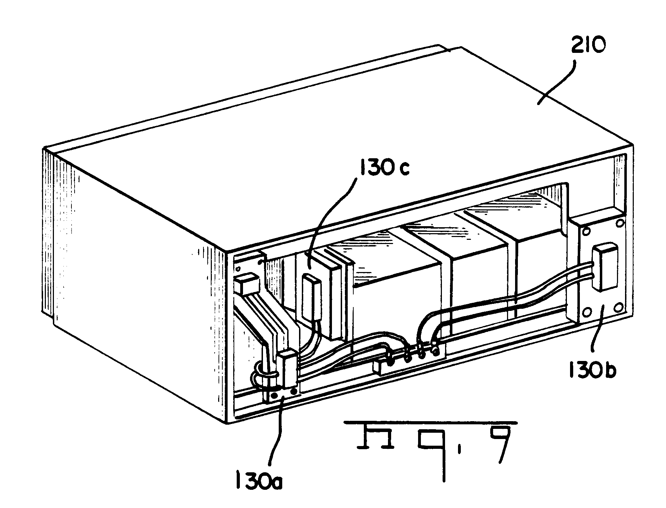

Multiple elements such as 104 could be employed at the ends or in the body of a given frame or between separate frame structures which each serve their own structural function as well as serving as a medium for a wire path and distribution. Reference is drawn to Figure 9 in which such an embodiment is shown as including several structural element components such as 130a, 130b and 130c. This embodiment is of advantage when the structural elements need to be disposed in distinct planes from one another, as is shown in Figure 9. It should be noted however, that this embodiment can be used when the structural elements are to be used within the same plane, but spaced apart, this embodiment producing a cost savings in that the structural element is not material intensive. It should also be noted that this configuration would include a smaller overall envelope for shipping and/or storage purposes.

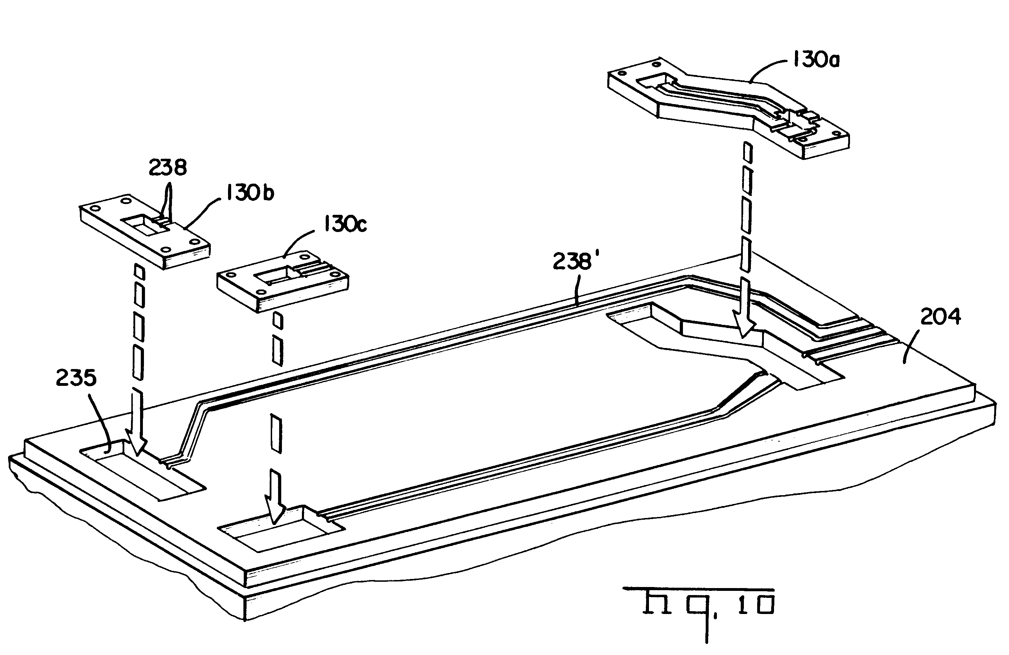

Thus it is believed that the tool jig fixture element could be made several feet in length if desired, as shown in Figure 10 as 204 resulting in there being several feet of wires 16 suitably terminated or not, which could then be made flexible to interconnect at any suitable point inside the apparatus unit 210 and not proximate to the frame element itself. When the structural elements are disposed within the apertures 235, the the grooves 238′ and 238 are aligned for rolling in the wires 16 as hereinbefore described. The lengths of the grooves 238′ between each aperture 235 will be the length of the free standing wire between the structural elements 130a, 130b, and 130c.

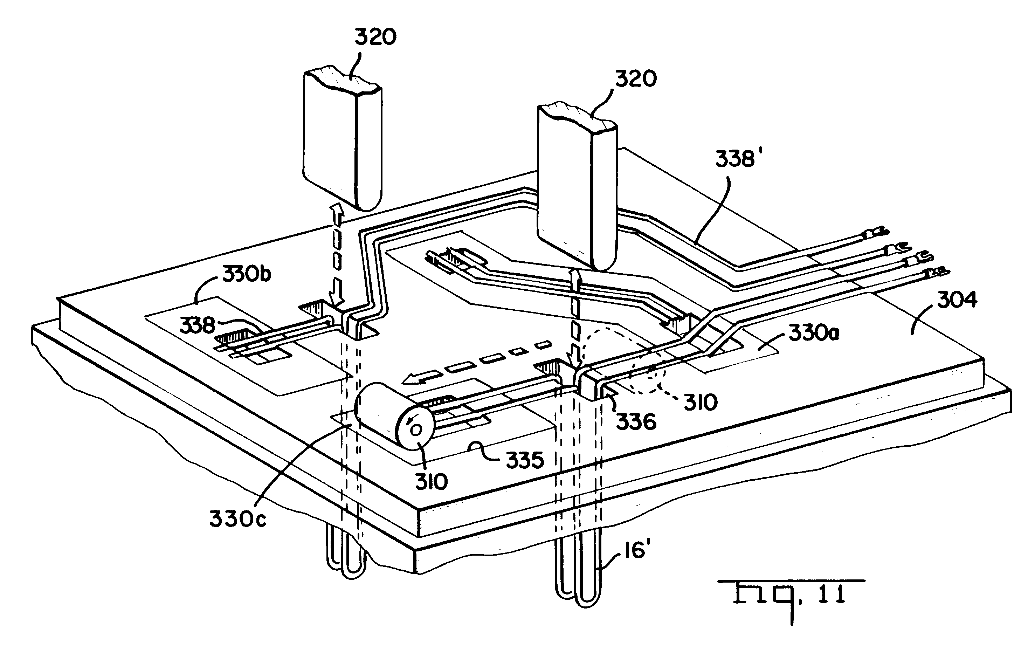

Alternatively, the tool jig fixture could be made more compact or from several unitary fixtures, in any event where the apertures 235 are more closely spaced, as shown in Figure 11. The fixture 304 includes a plurality of apertures 335 for the receipt of the structural members 330a, 330b and 330c, which when inserted have grooves 338 and 338′ aligned for receipt of wires 16. When the roller 310 traverses the fixture 304 to a position directly behind the aperture 336 (shown in phantom), a tooling bar 320 moves vertically downward through the aperture 336 to provide a length of free standing wire 16′. For the same application, the length of the free standing wire would be the same length as the length of the grooves 238′ as shown in Figure 10. Although somewhat more complicated, the process shown in Figure 11 requires less physical area and of course, less travel of the roller assembly, due to the proximity of the apertures 335.

Referring again to Figures 5A-5D, the embodiment is shown such that the jig fixture bases are fixed and the roller and mechanism are movable up and down and in X and Y senses, it is contemplated that the mechanism may be made to have only a Z motion up or down with the base being made movable in X and Y directions as a typical X-Y driven table widely used in industry today. In such event, the table carrying the frame would move under the fixed mechanism, the roller of course rotating as necessary to implant wires in grooves appropriately.

In Figure 5C, the ends of the wires 16 are shown as terminated by the addition of terminals 18. It is contemplated that the wires may be terminated following the wire rolling operation step by using the frame itself to hold the wires and position them relative to terminal crimping machinery. This applies, of course, to those wires left extending from the frame.

Referring now to Figure 6A, a representative segment of the lower leg of the frame 30 is shown as element 62 including grooves 38 having a representative wire 16 laid in the right-hand groove. The grooves 38 are made to include periodically therealong wire retaining indentation shown as 64 in Figure 6A which tend to pinch the wire, compressing the insulation thereof and locking or fixing the wire within the grooves. The wire retaining structure represented by 64 would be chosen to accommodate the wire diameters employed with the frame in a light wedging fit, holding the wires but readily allowing the wires to be pressed therewithin by the action of the roller 60. Elements 64 may be molded into the frame with its initial manufacture.

Figure 6B shows an alternative embodiment wherein the body of the material of element 62 is made to include between the grooves 38 a number of apertures shown as 66 which can be deformed to lock the wires in place within the grooves. In Figure 6B, the aperture 66 is shown as molded in the lower portion thereof and as deformed in the upper portion thereof. As can be discerned from Figures 6B and 6C, the deformation of the walls surrounding 66 creates a bulge 68 locking the wires within the grooves. Figure 6C shows an example to the left of a conductor wire 16 having insulation thereon and to the right of a conductor wire 16′ which is solid and uninsulated. With respect to the embodiments of Figure 6B and 6C, the frame would be employed as heretofore described with the wires being rolled therein and thereafter, an additional mechanism such as 110 having an end effector carrying a tool to effect deformation of the frame as at 66, would be employed. The embodiment of Figure 6B and 6C would be preferred in the case of the use of wire of different diameters which might not have a wedging fit and thus be otherwise retained within the groove 38.

Figure 6D shows a section of the frame 30 wherein grooves 38 cross one another, allowing wires 16 to cross one another in an overlapping configuration. This cross over point is evidenced in the Figures 2 and 3A by numeral 41. In accordance with the invention, one of the wires, the lower wire 16, would be first rolled into position within its groove with the second wire run being subsequently rolled and with the frame being made to accommodate the volume of the two wires in a vertical sense.

While the embodiment of the invention as thus far illustrated has shown grooves receiving wires in a wedging fit, and means in the frame which can operate to lock wires within the grooves, other and more conventional means of tying the wires to the grooves including the use of tape or adhesive, screws, or other fasteners is of course also contemplated.

Figures 7A and 7B show a further embodiment of the invention with the frame 30 following wire layment to form a harness and with the frame positioned relative to a further jig shown as 120 having a series of projections shown as 122 extended over the surface thereof in alignment with the apertures 37 heretofore mentioned. In accordance with the teaching in Figures 7A and 7B, a frame having the wire 16 implanted therein in the manner heretofore described, is positioned over the jig fixture 120 with the projections 122 forming anvils and then with the terminals pressed into the frame as indicated by the arrows in Figures 7A and 7B to terminate the wires within the slots 76, the beveled portions 77 serving to center the wires and assist their entry within the slots.

With the frame 30 being brought onto the jig base 120, the wire 16 may be terminated by a series of terminals shown as 70 in both Figures 7A and 7B. The terminals 70 include forwardly extending contact spring elements 72 shaped and formed to receive terminal blades inserted therein the manner shown in Figure 8, which terminal blades interconnect components as will be described. The base of each of the terminals 70 includes a series of flat, plate-like projections 74 each containing a slot 76 ending in a beveled portion 77 which forms the well-known termination concept known as insulation displacement and widely referred to as IDC or Insulation Displacement Connector. The terminal 70 is typically formed out of a suitable conductive sheet metal material such as a brass or phosphor-bronze stamped and formed and where necessary plated, with the spring elements 72 made to have suitable characteristics for repeated plugging in of tabs or blades. The characteristics of the metal must include sufficient strength in conjunction with the geometry and thickness thereof to provide slotted beam structures formed by the slots 76 to grip and hold the conductive portions of the wire 16 while penetrating the insulation thereof during insertion of the wires within the slot. The terminals are further provided with one or more barbs such as 78 shown in Figure 7B which operate to engage portions of the plastic material of the element 44 interiorly thereof to lock the terminals to the frame.

Alternatively, the terminals 70 may be partially preloaded into the frame, being inserted from the rear thereof with surfaces such as 78 engaging the interior of the plastic portions 44, and with the end edges 77 forming a trough at a depth substantially equal to the depth of the grooves. Thereafter, the wires may be rolled into the slots with the wire portions resting within the troughs formed by the outer ends 77 of the contacts. The contacts would be punched down such that the wires are terminated into the slots by anvils (not shown), the frame selectively being held with sufficient bearing surfaces proximate to 44 to avoid undue stressing of the frame and the boxlike structures formed by the terminals. As can be discerned from Figure 7B, the terminals 70 in their boxlike structures include slotted beam structures arranged at right angles so as to accommodate wires 16 laid in grooves arranged in X or Y directions to make the terminal more universal with respect to orientation. Preferably the terminal 70 would be positioned in the frame cavity with the terminal contact element 72 having only a single orientation. Termination could still be made to conductors oriented in either of the two orthogonal directions. It is contemplated that slot 76 may be made sufficiently long so as to permit commoning of two wires laid in a cross over relationship as heretofore described to effect electrical commoning or to provide an output from two separate wires 16. A further alternative which is contemplated includes fully inserting the terminals within the frame and subsequently rolling the wires directly into the IDC slots 76 of the terminals.

Figure 8 shows a wire harness formed in a frame 30 with components 82 aligned and positioned to be plugged into the frame. Terminals 84 are included on each component to engage the terminals 70 as heretofore described. The components 82 may be taken to include the usual components of electrical, electronic and electrically powered apparatus of all kinds. They may contain switches or timers, lights or solid state packages including logic and memory, fuse boxes, transformers, various sensors, detectors, and so forth. The components 82 are plugged into the frame to engage with the portions heretofore shown in Figures 4 and 7A. With the components 82 plugged into the frame 30 and supported thereby by portions 42-48, the frame may be tested out and then installed into the apparatus unit 10 with the fastening means 13 locking the frame into the unit as a permanent structural part thereof. Thereafter, the knobs 12 may be added to the components. It is contemplated that a frame 30 may be installed as wired and terminated into a unit with the components 82 added thereafter and during the production assembly phase of manufacturing if there is sufficient access. In the illustrative embodiment here shown, such access is not provided but it may in many instances allow for an access.

With respect to the figures heretofore discussed and described, the preferred embodiment of the invention method and an illustrative apparatus has been shown to effect provision of a wiring harness incorporated into a structural frame or electric range, along with suitable termination, interconnection and components.

A wide variety of variations in frame shape, geometry, and type are contemplated as well as variations in method.

With respect to the teaching in this disclosure, reference has been made to a roller to effect implantation of wires and reference has been made to certain U.S. Patents that teach the employment of rollers. It is also contemplated that in certain applications, particularly those where wiring insertion involves grooves of a short length and small size, the insertion or implantation of wires may be accomplished by an edge of plastic or other material driven along the surface of the element containing the grooves. This concept of using a non-roller action to implant wires is taught in U.S. Patent Number 4,132,252.

The embodiments involve the use of a structural member containing grooves into which wires are implanted, with a segment of wires placed within a groove and thereafter the remainder of the wire driven by means such as a roller into the remainder of the groove. The wire may be started or intiated in the groove of a tool as part of a fixture or in a portion of the groove within the frame element itself. In certain instances and applications, all starting segments of wires may be displaced in appropriate tools or in certain instances, all may be started within the grooves of the frame. Both are contemplated in the sense that there is an end segment placed within the groove followed by an implantation effected as by rolling.

## Claims

1. Apparatus for making a Wiring harness (14) having a plurality of wires (16) terminated to a plurality of electrical components (24), the apparatus comprising a structural element in the form of a wire retaining frame (30) having grooves (38) extending along one surface thereof, each groove (38) communicating with an aperture (34,36) in said frame (30), and terminal means (70) insertable into each aperture (34,36) for engaging a wire (16) progressively implanted in the groove (38) communicating with that aperture (34,36); characterized by a jig (102) having a plurality of projections (104,106) which are engageable in corresponding apertures (34,36) in the wire retaining frame (30), each projection (104,106) having grooves (38') matching with the grooves (38) in the frame (30), so that wires (16) can be laid continuously along the grooves (38) in the frame (30) and through the grooves (38') in projections (104,106), whereby upon removal of the jig (102) from the wire retaining frame (30), the wires (16) are left free standing across the apertures (34,36), for engagement by said terminal means (70).

2. Apparatus as claimed in claim 1, further characterized by a roller (60) or a wire implanting instrument having a wire implanting edge, which is movable relative to the wire retaining frame (30) for continuously and progressively implanting each wire (16) in a respective groove (38) in the frame (30) and a respective groove (38') in a respective projection (104,106) of the jig (102).

3. Apparatus as claimed in claim 2, characterized by a mechanism (110) supporting the roller (60) on a robotic arm (112) for driving the mechanism (110) in X, Y and Z directions relative to the frame (30).

4. Apparatus as claimed in claim 2 or 3, characterized in that the roller (60) is made of an elastomeric material, or comprises a rigid core coated with an elastomeric material.

5. Apparatus as claimed in claim 2, characterized by an X-Y driven table for moving the jig (102) and the frame (30) relative to the roller (60) or the wire implanting instrument.

6. A method of making a wiring harness (14) having a plurality of wires (16) terminated to a plurality of electrical components, by means of harness making apparatus as claimed in claim 1, the method comprising the steps of:
placing the wire retaining frame (30) on the jig (102) with each projection (104,106) on the jig (102) extending through a respective aperture (34,36) in the frame (30);
bringing about relative movement, in X, Y and Z directions, between the frame (30) and a roller (60) or a wire implanting edge of a wire implanting instrument, continuously and progressively to implant each wire (16) in a respective groove (38) in the frame (30) and in a respective groove (38') in a respective projection (104,106);
removing the frame (30) from the jig (102) so that the wires (16) are left free standing across the apertures (34,36); and
inserting a terminal means (70) into each aperture (34,36) to make electrical connection with the portion of the wire (16) extending there across.

7. A method as claimed in claim 6, comprising the steps of deforming portions (64,68) of the wire retaining frame (30), which portions are between adjacent grooves (38) in the frame (30), to lock the wires in said grooves (38) in the frame (30).

8. A method as claimed in claim 6 or 7, wherein said jig (102) is fixed and said roller (60) or implanting instrument is moved relative to said frame (30).

9. A method as claimed in claim 6 or 7, wherein the jig is moved by means of an X-Y table relative to the roller (60) or the implanting instrument.

## Patentansprüche

1. Vorrichtung zum Herstellen eines Draht-Kabelbaums (14), der eine Vielzahl von Drähten (16) hat, die an eine Vielzahl von elektrischen Komponenten (24) angeschlossen sind, wobei die Vorrichtung ein Strukturelement in der Form eines Drahthalterahmens (30) aufweist, der Nuten (38) hat, die sich längs dessen einer Oberfläche erstrecken, wobei jede Nut (38) mit einer Öffnung (34, 36) in dem Rahmen (30) in Verbindung steht, und wobei Anschlußmittel (70) in jede Öffnung (34, 36) einsetzbar sind, um einen Draht (16) zu ergreifen, der allmählich in die Nut (38) eingesetzt wird, die mit dieser Öffnung (34, 36) in Verbindung steht, **gekennzeichnet** durch eine Setzvorrichtung (102), die eine Vielzahl von Vorsprüngen (104, 106) hat, die zum Eingriff in entsprechende Öffnungen (34, 36) in dem Drahthalterahmen (30) gebracht werden können, wobei jeder Vorsprung (104, 106) Nuten (38') hat, die zu den Nuten (38) in dem Rahmen (30) passen, so daß Drähte (16) kontinuierlich längs der Nuten (38) in dem Rahmen (30) und durch die Nuten (38') in den Vorsprüngen (104, 106) gelegt werden können, wodurch nach dem Entfernen der Setzvorrichtung (102) von dem Drahthalterahmen (30) die Drähte (16) freigelassen sind und quer über die Öffnungen (34, 36) zum Eingriff durch die Anschlußmittel (70) verlaufen.

2. Vorrichtung nach Anspruch 1, **gekennzeichnet durch** eine Rolle (60) oder ein Drahteinsetzinstrument, das eine Drahteinsetzkante hat, die relativ zu dem Drahthalterahmen (30) bewegbar ist, um kontinuierlich und allmählich jeden Draht (16) in eine entsprechende Nut (38) in dem Rahmen (30) und in eine entsprechende Nut (38') in einem Vorsprung (104, 106) der Setzvorrichtung (102) einzusetzen.

3. Vorrichtung nach Anspruch 2, **gekennzeichnet durch** einen Mechanismus (110), der die Rolle (60) auf einem Roboterarm (112) zum Antrieb des Mechanismus (110) in X-, Y- und Z-Richtungen relativ zu dem Rahmen (30) abstützt.

4. Vorrichtung nach Anspruch 2 oder 3, **dadurch gekennzeichnet,** daß die Rolle (60) aus einem elastomeren Material hergestellt ist oder einen starten Kern aufweist, der mit einem elastomeren Material beschichtet ist.

5. Vorrichtung nach Anspruch 2, **gekennzeichnet durch** einen in X- und Y-Richtung angetriebenen Tisch zum Bewegen der Setzvorrichtung (102) und des Rahmens (30) relativ zu der Rolle (60) oder dem Drahteinsetzinstrument.

6. Verfahren zum Herstellen eines Drahtkabelbaums (14), der eine Vielzahl von Drähten (16) hat, die an eine Vielzahl von elektrischen Komponenten angeschlossen sind, mittels der in Anspruch 1 beanspruchten Kabelbaum-Herstellvorrichtung, wobei das Verfahren die folgenden Schritte aufweist:
- Aufsetzen des Drahthalterahmens (30) auf die Setzvorrichtung (102), wobei sich jeder Vorsprung (104, 106) an der Setzvorrichtung (102) durch eine entsprechende Öffnung (34,36) in dem Rahmen (30) hindurch erstreckt,
- Herbeiführen einer Relativbewegung in X-, Y- und Z-Richtungen zwischen dem Rahmen (30) und einer Rolle (60) oder einer Drahteinsetzkante eines Drahteinsetzinstruments, um kontinuierlich und allmählich jeden Draht (16) in eine entsprechende Nut (38) in dem Rahmen (30) und in eine entsprechende Nut (38') in einem Vorsprung (104, 106) einzusetzen,
- Entfernen des Rahmens (30) von der Setzvorrichtung (102), so daß die Drähte (16) quer über die Öffnungen (34, 36) verlaufend freigelassen werden, und
- Einsetzen eines Anschlußmittels (70) in jede Öffnung (34, 36) zur Herstellung einer elektrischen Verbindung mit demjenigen Teil des Drahtes (16), der sich darüber erstreckt.

7. Verfahren nach Anspruch 6 mit dem Schritt des Verformens von Teilen (64, 68) des Drahthalterahmens (30), die zwischen benachbarten Nuten (38) in dem Rahmen (30) angeordnet sind, um die Drähte in den Nuten (38) in dem Rahmen (30) zu verriegeln.

8. Verfahren nach Anspruch 6 oder 7, bei dem die Setzvorrichtung (102) fest ist und die Rolle (60) oder das Einsetzinstrument relativ zu dem Rahmen (30) bewegt ist.

9. Verfahren nach Anspruch 6 oder 7, bei dem die Einsetzvorrichtung mittels eines X-Y-Tischs relativ zu der Rolle (60) oder dem Einsetzinstrument bewegt wird.

## Revendications

1. Appareil pour réaliser un faisceau (14) de câblage ayant plusieurs fils (16) aboutissant à plusieurs constituants électriques (24), l'appareil comportant un élément structural sous la forme d'un bâti (30) de retenue de fils présentant des gorges (38) s'étendant le long de l'une de ses surfaces, chaque gorge (38) communiquant avec une ouverture (34, 36) dans ledit bâti (30), et un moyen à borne (70) pouvant être inséré dans chaque ouverture (34, 36) pour engager un fil (16) implanté progressivement dans la gorge (38) communiquant avec cette ouverture (34, 36) ; caractérisé par un gabarit (102) ayant plusieurs saillies (104, 106) qui peuvent être engagées dans des ouvertures correspondantes (34, 36) dans le bâti (30) de retenue de fils, chaque saillie (104, 106) ayant des gorges (38') s'accordant avec les gorges (38) du bâti (30) afin que des fils (16) puissent être posés en continu le long des gorges (38) dans le bâti (30) et à travers les gorges (38') dans des saillies (104, 106), grâce à quoi, après que le gabarit (102) a été enlevé du bâti (30) de retenue de fils, les fils (16) sont laissés de façon à passer librement à travers les ouvertures (34, 36) pour être engagés par lesdits moyens à bornes (70).

2. Appareil selon la revendication 1, caractérisé en outre par un rouleau (60) ou un instrument d'implantation de fils ayant une arête d'implantation de fils, qui peut être déplacé par rapport au bâti (30) de retenue de fils pour implanter en continu et progressivement chaque fil (16) dans une gorge respective (38) du bâti (30) et dans une gorge respective (38') d'une saillie respective (104, 106) du gabarit (102).

3. Appareil selon la revendication 2, caractérisé par un mécanisme (110) supportant le rouleau (60) sur un bras de robot (112) pour entrainer le mécanisme (110) dans des directions X, Y et Z par rapport au bâti (30).

4. Appareil selon la revendication 2 ou 3, caractérisé en ce que le rouleau (60) est formé d'une matière élastomérique, ou comporte une âme rigide revêtue d'une matière élastomérique.

5. Appareil selon la revendication 2, caractérisé par une table à commande X-Y pour déplacer le gabarit (102) et le bâti (30) par rapport au rouleau (60) ou à l'instrument d'implantation de fils.

6. Procédé de réalisation d'un faisceau (14) de câblage ayant plusieurs fils (16) aboutissant à plusieurs constituants électriques, au moyen d'un appareil de réalisation de faisceau selon la revendication 1, le procédé comprenant les étapes qui consistent :
à placer le bâti (30) de retenue de fils sur le gabarit (102), chaque saillie (104, 106) sur le gabarit (102) pénétrant dans une ouverture respective (34, 36) du bâti (30) ;
à provoquer un mouvement relatif, dans les directions X, Y et Z, entre le bâti (30) et un rouleau (60) ou une arête d'implantation de fils d'un instrument d'implantation de fils, pour implanter en continu et progressivement chaque fil (16) dans une gorge respective (38) du bâti (30) et d'une gorge respective (38') d'une saillie respective (104, 106) ;
à enlever le bâti (30) du gabarit (102) afin que les fils (16) restent en traversant librement les ouvertures (34, 36) ; et
à insérer un moyen à borne (70) dans chaque ouverture (34, 36) afin de réaliser une connexion électrique avec la partie du fil (16) s'étendant à travers elle.

7. Procédé selon la revendication 6, comprenant les étapes qui consistent à déformer des parties (64, 68) du bâti (30) de retenue de fils, lesquelles parties se trouvent entre des gorges adjacentes (38) dans le bâti (30), afin de bloquer les fils dans lesdites gorges (38) du bâti (30).

8. Procédé selon la revendication 6 ou 7, dans lequel ledit gabarit (102) est fixe et ledit rouleau (60) ou instrument d'implantation est déplacé par rapport audit bâti (30).

9. Procédé selon la revendication 6 ou 7, dans lequel le gabarit est déplacé au moyen d'une table X-Y par rapport au rouleau (60) ou à l'instrument d'implantation.
